# FASCICULE DE BREVET EUROPEEN

(11) **EP 1 048 986 B1**
(45) Date de publication et mention de la délivrance du brevet: **18.12.2002**
(21) Numéro de dépôt: 00401105.2
(22) Date de dépôt: 20.04.2000
(51) Int. Cl.: G03F 7/42

(54) **Compositions pour le décapage de photorésists dans la fabrication de circuits intégrés**
Zusammensetzung zur Entschichtung von Photolack in der Herstellung von integrierten Schaltungen
Compositions for stripping photoresists in the manufacture of integrated circuits

(30) Priorité: 26.04.1999 FR 9905237
(43) Date de publication de la demande: 02.11.2000
(73) Titulaire: Atofina, 92091 Paris La Défense Cedex (FR)
(72) Inventeur: Lallier, Jean-Pierre, 95220 Herblay (FR)
(74) Mandataire: Leboulenger, Jean

(56) Documents cités:
- EP-A- 0 578 507
- EP-A- 0 596 515
- US-A- 5 417 877
- US-A- 5 496 491

## Description

La présente invention concerne le domaine des circuits intégrés et a plus particulièrement pour objet une composition de décapage des résines photosensibles utilisées pour la fabrication de circuits intégrés.

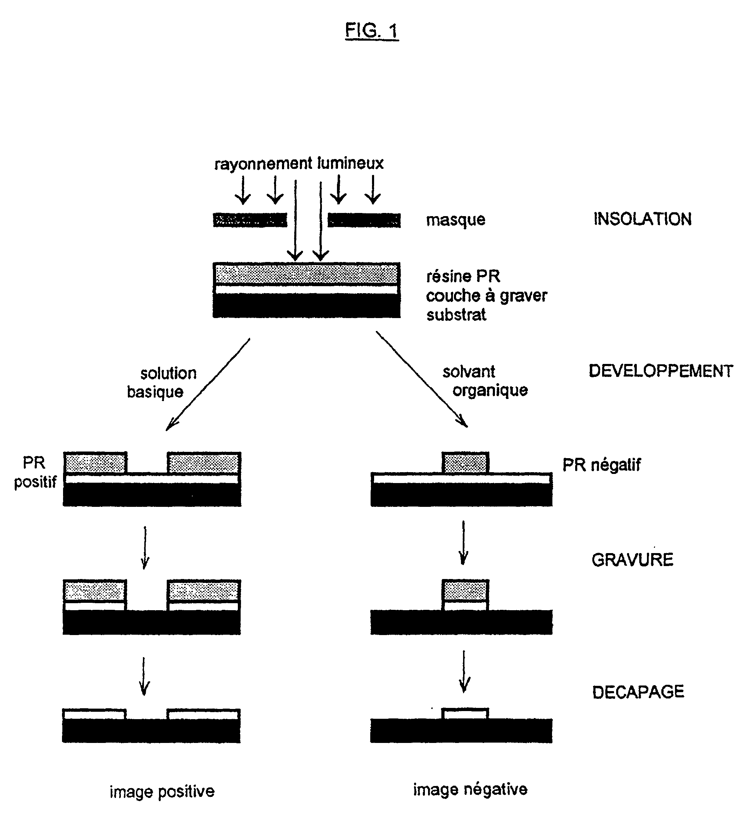

La technique de base mise en oeuvre pour fabriquer un circuit intégré est la photolithographie. Selon un procédé appelé "planar" et inventé par la firme Fairchild en 1959, un "wafer", c'est-à-dire une tranche de silicium polycristallin pure (à 1 ppm près) d'environ 0,7 mm d'épaisseur et 200 mm de diamètre, dont la surface a été polie pour la rendre parfaitement lisse, est recouvert d'une couche à graver constituée d'un diélectrique (par exemple SiO₂) ou d'un métal (par exemple l'aluminium), puis on dépose sur l'ensemble un film de 1 à 2 µm d'épaisseur d'un "photoresist" (ci-après PR), c'est-à-dire une résine photosensible composée d'un polymère et d'un photo sensibilisateur. On projette ensuite une lumière visible ou avantageusement ultraviolette à travers un masque dont les surfaces opaques forment la réplique du dessin désiré, si bien que certaines parties de la résine PR sont exposées et d'autres non. Après cette étape d'insolation, on développe la résine PR soit, s'il s'agit d'un PR positif, dans une solution basique dissolvant les parties exposées, soit, s'il s'agit d'un PR négatif, dans un solvant organique dissolvant les parties masquées. Dans les creux ainsi formés, on enlève alors par une solution acide ou par un plasma la zone découverte de la couche diélectrique (SiO₂, silice modifiée, carbure de silice) ou métallique (AI, Cu, Cr, W...). Après cette opération dite de gravure, le reliquat de résine PR doit ensuite être éliminé par une opération de décapage, appelée "stripping de PR" et, comme montré sur le schéma de la figure 1 annexée, on obtient finalement une image positive ou une image négative.

La fabrication de circuits intégrés est une opération industrielle extrêmement élaborée dont l'exposé précédent et le schéma de la figure 1 ne donnent ici qu'une idée générale. Sa difficulté tient essentiellement à la petitesse des objets manipulés, puisque les transistors fabriqués de nos jours présentent une largeur de grille de 0,25 µm. La fabrication doit être faite dans des enceintes dites "salles blanches", d'où la poussière est systématiquement éliminée ; des salles blanches de classe I comptent par m³ moins de 30 particules de taille supérieure à 0,12 µm alors qu'une pièce normale en compte 530 millions par m³.

Un photoresist est une formulation de composés organiques dont la solubilité change lorsqu'il est exposé à un rayonnement lumineux. Développées initialement pour l'imprimerie, les formulations photoresist sont utilisées depuis une trentaine d'années en microlithographie pour la fabrication des circuits intégrés ; leur composition (% poids) est généralement la suivante :
- résine 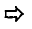 25-55 %
- photo sensibilisateur 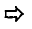 2-30 %
- solvant 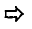 40-70 %
- additifs 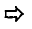 10-1000 ppm

L'insolation d'un photoresist provoque une transformation chimique qui modifie sa solubilité dans certains solvants ou dans certaines conditions de pH. Ainsi, les régions insolées d'un photoresist positif sont le siège de réactions de réarrangements photochimiques et deviennent plus solubles dans les solutions alcalines que les régions qui n'ont pas subi le rayonnement. Pour les Chemical Amplified Photoresist (CAP), le polymère photoresist est rendu soluble parce qu'un second composé chimique (photo générateur d'acide) libère un acide sous éclairement ; cet acide a une action catalytique sur le polymère parce qu'il provoque une réaction chimique faisant apparaître des groupements solubles dans un développeur basique. Pour les résines de photoresists négatifs, les parties insolées sont le siège d'une réaction de photo polymérisation qui entraîne la formation d'un milieu constitué de macromolécules dont les masses moléculaires sont bien plus élevées que celles de départ ; il s'ensuit une diminution notable de la solubilité dans un solvant organique.

Les photoresists positifs sont généralement plus facile à décaper que les photoresists négatifs. Ceci est dû au fait que les résines positives que l'on décape n'ont pas subi le rayonnement, contrairement aux résines négatives qui se sont modifiées et qui sont souvent insolubles dans la plupart des solvants. Mais en fait, plus que le PR lui-même, c'est un polymère nommé SWP (Side Wall Polymer) qui se forme sur les côtés des motifs lors de la gravure par plasma qui est le plus difficile à éliminer. Ce polymère contient typiquement des atomes de métaux, de carbone et d'halogènes (Cl, F, Br).

Il existe deux méthodes pour ôter le photoresist du wafer :
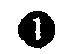 le "dry stripping" ou "ashing" (décapage par voie sèche) qui utilise un plasma à oxygène, et
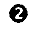 le "wet stripping" (décapage par voie humide) qui utilise des solvants.

Ces deux méthodes n'ont pas la même action sur le photoresist et sont utilisées, la plupart du temps, en complémentarité de façon à conjuguer les avantages que peuvent présenter chacune d'elles. En effet, le "dry stripping" enlève mieux le PR que les contaminants et inversement pour le "wet stripping". Le "dry stripping" est particulièrement inefficace pour éliminer les SWP.

Les hydrocarbures halogénés (chlorure de méthylène, tétrachloroéthylène) ont été les premiers décapants de PR ("strippers") utilisés : ils présentaient l'avantage de décaper aussi bien les PR positifs que négatifs, et cela avec une parfaite efficacité. Néanmoins, leur forte toxicité vis-à-vis de l'environnement ainsi que leur volatilité trop élevée ont amené l'industrie électronique à rechercher des formulations de substitution.

Le brevet US 5,496,491 concerne des compositions de décapage de résines photosensibles qui contiennent un solvant organique polaire une amine basique et un inhibiteur de corrosion.

Il a maintenant été trouvé qu'on peut obtenir d'excellentes performances dans le décapage des photoresists négatifs et des photoresists positifs en utilisant un mélange de diméthylsulfoxyde (DMSO) ou de N-méthylpyrrolidone (NMP) et de 3-méthoxypropylamine (MOPA).

Le mélange selon l'invention contient en masse de 30 à 95 % de DMSO ou NMP et de 70 à 5 % de MOPA. De préférence, on utilise un mélange contenant de 65 à 95% de DMSO ou de NMP et 35 à 5% de MOPA; un mélange plus particulièrement préféré est celui qui contient environ 70 % en poids de DMSO et 30 % en poids de MOPA.

Les mélanges DMSO-MOPA et NMP-MOPA selon l'invention peuvent être utilisés tels quels pour le décapage des photoresists, mais il est avantageux de leur ajouter un peu d'eau à raison de 0 à 10 parties en poids d'eau (de préférence 0,3 à 7 parties) pour 100 parties de mélange DMSO-MOPA ou NMP-MOPA.

Il est également avantageux d'introduire dans les compositions de décapage selon l'invention une petite quantité d'inhibiteur de corrosion tel que le catéchol et, de préférence, le tolyltriazolate de sodium. Cette quantité peut aller jusqu'à 10 parties en poids pour 100 parties de mélange DMSO-MOPA ou NMP-MOPA, mais est de préférence comprise entre 0,3 et 7 parties.

Une composition particulièrement préférée pour le décapage de photorésists positifs comprend environ 69 parties de DMSO, 30 parties de MOPA, 0,5 partie de tolyltriazolate de sodium et 0,5 partie d'eau. Cette composition peut en outre être utilisée pour le nettoyage après décapage ("post-stripping") d'un circuit cuivre/diélectrique à faible constante k.

Les compositions de décapage selon l'invention peuvent être mises en oeuvre à une température comprise entre la température ambiante et 50°C, de préférence entre 20 et 30°C.

Les exemples suivants illustrent l'invention sans la limiter.

### EXEMPLE 1

On a utilisé des wafers à motifs de silice avec un PR positif (épaisseur = 1 µm) à base d'une résine positive (Shipley DUV XP 90166).

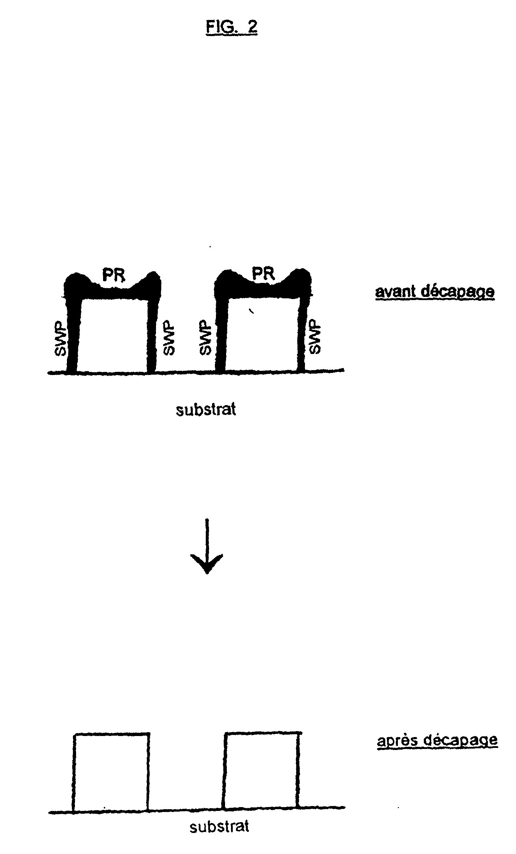

Les motifs à décaper étaient recouverts partiellement de résine PR sur le dessus et de SWP sur les côtés, leur donnant une forme bombée caractéristique. Un stripper efficace doit être capable d'éliminer ces revêtements ainsi que les résidus entre les motifs sans toutefois attaquer le motif lui-même. Seule une visualisation au microscope électronique à balayage permettant des grossissements de X 10.000 à X 100.000 permet une évaluation morphologique efficace et reproductible. Un décapage efficace correspond à la transformation morphologique illustrée sur la figure 2.

On a décapé ces wafers à motifs SiO₂ et PR positif au moyen de trois mélanges A, B et C selon l'invention ayant la composition pondérale indiquée dans le tableau suivant :

| Mélanges | DMSO | MOPA | Catéchol | Eau |
|---|---|---|---|---|
| A | 35 | 55 | 5 | 5 |
| B | 60 | 30 | 5 | 5 |
| C | 81 | 9 | 5 | 5 |

en opérant selon la procédure suivante en quatre étapes :
(a) Décapage à 25°C pendant 30 minutes sous agitation par ultrasons ;
(b) Prérinçage pendant 5 minutes à 25°C avec la même formulation que pour le décapage, sous agitation circulaire (50 tours/min), pour améliorer l'élimination des résidus ;
(c) Rinçage pendant 15 minutes à l'eau bipermutée à 25°C sous agitation circulaire ;
(d) Séchage à l'air à 80°C pendant 10 minutes.

Après ce traitement, l'examen des wafers au microscope électronique à balayage (grossissement: 10000) montrait une excellente élimination des SWP et PR sans attaque des motifs de silice.

### EXEMPLE 2

On a obtenu d'aussi bons résultats en remplaçant dans l'exemple 1 les mélanges A, B et C par un mélange selon l'invention ayant la composition pondérale suivante :
- DMSO: 69 parties
- MOPA: 30 parties
- tolyltriazolate de sodium: 0,5 partie
- eau: 0,5 partie

## Revendications

1. Composition pour le décapage d'un photoresist, **caractérisée en ce qu'**elle contient en masse 30 à 95 % de diméthylsulfoxyde (DMSO) ou de N-méthylpyrrolidone (NMP) et 70 à 5 % de 3-méthoxypropylamine (MOPA).

2. Composition selon la revendication 1 contenant de 65 à 95 % de DMSO ou de NMPet de 35 à 5 % de MOPA, de préférence environ 70 % de DMSO et 30 % de MOPA.

3. Composition selon la revendication 1 ou 2, **caractérisée en ce qu'**elle contient également de l'eau à raison de 0 à 10 parties en poids d'eau pour 100 parties de mélange DMSO-MOPA ou NMP-MOPA.

4. Composition selon la revendication 3 comprenant 0,3 à 7 parties d'eau pour 100 parties de mélange DMSO-MOPA ou NMP-MOPA.

5. Composition selon l'une des revendications 1 à 4 contenant en outre un inhibiteur de corrosion à raison de 0 à 10 parties (de préférence 0,3 à 7) pour 100 parties de mélange DMSO-MOPA ou NMP-MOPA.

6. Composition selon la revendication 5 dans laquelle l'inhibiteur de corrosion est le catéchol.

7. Composition selon la revendication 5 dans laquelle l'inhibiteur de corrosion est le tolyltriazolate de sodium.

8. Composition selon la revendication 7 contenant environ 69 parties de DMSO, 30 parties de MOPA, 0,5 partie de tolyltriazolate de sodium et 0,5 partie d'eau.

9. Utilisation d'une composition selon l'une des revendications 1 à 8 pour le décapage d'un photoresist et/ou son nettoyage après décapage.

## Claims

1. Composition for the stripping of a photoresist, **characterized in that** it contains, by mass, from 30 to 95% dimethyl sulphoxide (DMSO) or N-methylpyrrolidone (NMP) and 70 to 5% 3-methoxypropylamine (MOPA) .

2. Composition according to Claim 1, containing from 65 to 95% DMSO or NMP and from 35 to 5% MOPA, preferably approximately 70% DMSO and 30% MOPA.

3. Composition according to Claim 1 or 2, **characterized in that** it also contains water in an amount from 0 to 10 parts by weight of water per 100 parts of DMSO-MOPA or NMP-MOPA mixture.

4. Composition according to Claim 3, comprising 0.3 to 7 parts of water per 100 parts of DMSO-MOPA or NMP-MOPA mixture.

5. Composition according to one of Claims 1 to 4, furthermore containing a corrosion inhibitor in an amount from 0 to 10 (preferably 0.3 to 7) parts per 100 parts of DMSO-MOPA or NMP-MOPA mixture.

6. Composition according to Claim 5, in which the corrosion inhibitor is catechol.

7. Composition according to Claim 5, in which the corrosion inhibitor is sodium tolyltriazolate.

8. Composition according to Claim 7, containing approximately 69 parts of DMSO, 30 parts of MOPA, 0.5 part of sodium tolyltriazolate and 0.5 part of water.

9. Use of a composition according to one of Claims 1 to 8 for the stripping of a photoresist and/or its post-stripping cleaning.

## Patentansprüche

1. Zusammensetzung zum Entfernen eines Photolacks, **dadurch gekennzeichnet, daß** sie massenbezogen 30 bis 95 % Dimethylsulfoxid (DMSO) oder N-Methylpyrrolidon (NMP) und 70 bis 5 % 3-Methoxypropylamin (MOPA) enthält.

2. Zusammensetzung nach Anspruch 1, enthaltend 65 bis 95 % DMSO oder NMP und 35 bis 5 % MOPA, vorzugsweise etwa 70 % DMSO und 30 % MOPA.

3. Zusammensetzung nach Anspruch 1 oder 2, **dadurch gekennzeichnet, daß** sie gleichermaßen Wasser in Mengen von 0 bis 10 Gewichtsteilen Wasser auf 100 Teilen der Mischung DMSO-MOPA oder NMP-MOPA enthält.

4. Zusammensetzung nach Anspruch 3, enthaltend 0,3 bis 7 Gewichtsteile Wasser auf 100 Teile der Mischung DMSO-MOPA oder NMP-MOPA.

5. Zusammensetzung nach einem der Ansprüche 1 bis 4, enthaltend außerdem einen Korrosionsinhibitor in Mengen von 0 bis 10 Teilen (vorzugsweise 0,3 bis 7 Teilen) auf 100 Teile der Mischung DMSO-MOPA oder NMP-MOPA.

6. Zusammensetzung nach Anspruch 5, wobei der Korrosionsinhibitor Catechol ist.

7. Zusammensetzung nach Anspruch 5, wobei der Korrosionsinhibitor Natriumtolyltriazolat ist.

8. Zusammensetzung nach Anspruch 7, enthaltend etwa 69 Teile DMSO, 30 Teile MOPA, 0,5 Teile Natriumtolyltriazolat und 0,5 Teile Wasser.

9. Verwendung einer Zusammensetzung nach einem der Ansprüche 1 bis 8 zum Entfernen eines Photolacks und/oder seiner Reinigung nach Entfernen.
